# EUROPÄISCHE PATENTSCHRIFT

(11) **EP 1 842 268 B1**
(45) Veröffentlichungstag und Bekanntmachung des Hinweises auf die Patenterteilung: **28.08.2019**
(21) Anmeldenummer: 06705870.1
(22) Anmeldetag: 26.01.2006
(51) Int. Cl.: H01S 5/026, H01S 5/323

(54) **III/V-HALBLEITER**
III/V SEMICONDUCTOR
SEMI-CONDUCTEUR III/V

(30) Priorität: 26.01.2005 DE 102005004582; 26.01.2005 US 647106 P
(43) Veröffentlichungstag der Anmeldung: 10.10.2007
(73) Patentinhaber: Philipps-Universität Marburg, 35032 Marburg (DE)
(72) Erfinder: KUNERT, Bernardette, 35041 Marburg (DE); KOCH, Jörg, 35232 Dautphetal (DE); REINHARD, Stefan, 35282 Rauschenberg-Bracht (DE); VOLZ, Kerstin, 35232 Dautphetal (DE); STOLZ, Wolfgang, 35041 Marburg (DE)
(74) Vertreter: Jungblut, Bernhard Jakob
(86) Internationale Anmeldenummer: PCT/DE2006/000140
(87) Internationale Veröffentlichungsnummer: WO 2006/079333

(56) Entgegenhaltungen:
- EP-A- 0 621 646
- EP-A- 0 896 406
- US-A- 5 937 274
- US-A1- 2002 195 607
- H. YONEZU: "Control of structural defects in group III-V-N alloys grown on Si" Semiconductor Science and Technology IOP Publishing UK, Bd. 17, Nr. 8, 1. August 2002 (2002-08-01), Seiten 762-768, XP002468397 stevenage ISSN: 0268-1242
- IZADIFARD M ET AL: "Evaluation of optical quality and defect properties of GaNxP1 #x2212;x alloys lattice matched to Si" APPLIED PHYSICS LETTERS, AIP, AMERICAN INSTITUTE OF PHYSICS, MELVILLE, NY, US, Bd. 85, Nr. 26, 27. Dezember 2004 (2004-12-27), Seiten 6347-6349, XP012063933 ISSN: 0003-6951
- KUNERT B ET AL: "Direct-band-gap Ga(NAsP)-material system pseudomorphically grown on GaP substrate", APPLIED PHYSICS LETTERS, AIP, AMERICAN INSTITUTE OF PHYSICS, MELVILLE, NY, US, vol. 88, no. 18, 4 May 2006 (2006-05-04), pages 182108-182108, XP012081411, ISSN: 0003-6951, DOI: 10.1063/1.2200758

## Beschreibung

### Gebiet der Erfindung

Die Erfindung betrifft einen neuen III/V-Halbleiter, eine Halbleiterschicht bestehend aus einem solchen Halbleiter, eine monolithisch integrierte Halbleiterstruktur enthaltend eine solche Halbleiterschicht, Verwendungen eines solchen Halbleiters oder einer solchen Halbleiterschicht, sowie ein Verfahren zur Herstellung einer solchen Halbleiterschicht. Die Erfindung ist wie in den Ansprüchen 1 und 5 definiert.

Hintergrund der Erfindung und Stand der Technik Im Bereich der Computertechnologie besteht ein ständig wachsender Bedarf für höhere Prozessierungs- und Signalleitungskapazitäten in Verbindung mit hoher Zuverlässigkeit und Flexibilität. In der Vergangenheit hat die Chiptechnologie in Hinblick auf Integrationsdichte und Arbeitsgeschwindigkeiten bzw. Taktfrequenzen einen rapiden Fortschritt gemacht. Mit dem Fortschritt dieses Trends entstehen Probleme bei der Verbindung schneller Chips. Kritische Gesichtspunkte in Verbindung mit Hochgeschwindigkeitsverbindungen sind Zuverlässigkeit, Kosten, on-Chip Treibergröße und -leistung, Kreuzsprechen, Signalverzerrungen und Mangel an Flexibilität im Chipdesign. Verbindungen zwischen Chips durch Verwendung optoelektronischer Komponenten und optischer Wellenleiter bieten eine Lösung für viele dieser Verbindungsprobleme. Optische Verbindungen haben eine extrem hohe Bandbreite und sind vergleichsweise unempfindlich gegen Kreuzsprechen und andere Interferenzen. Durch Nutzung dieser Eigenschaften optischer Verbindungen kann es möglich werden, Hochgeschwindigkeitschips über optische Kanäle miteinander zu verbinden und eine beachtliche Verbesserung in Hinblick auf Verbindungsdichte, Stromverbrauch, Interferenzen und Kreuzsprechen zu erreichen.

Übliche hochintegrierte Schaltkreise basieren auf der Si-Technologie. Silicium ist jedoch ein indirekter Halbleiter, und die Erstellung effizienter optoelektronischer Komponenten in Si-Technologie ist folglich kaum möglich. Effiziente optoelektronische Bauelemente sind demgegenüber mit der Technologie der III/V-Halbleiter, beispielsweise der GaAs-Technologie, herstellbar, da es sich bei diesen Halbleitern vielfach um direkte und folglich mit hoher Effizienz lichtemittierende und -absorbierende Halbleiter handelt.

Bei der Herstellung von integrierten Schaltkreisen wird üblicherweise mit Epitaxieverfahren gearbeitet. Sollen nunmehr Kontakte zwischen Schichten auf Basis der Si-Technologie mit Schichten auf Basis der Technologie der III/V-Halbleiter hergestellt werden, ist es problematisch, dass die Gitterkonstanten der jeweiligen Materialien unterschiedlich sind (dies gilt auch bei Einsatz von GaP Substraten an Stelle von Si Substraten). Hieraus folgt, dass im Rahmen des epitaktischen Wachstums von III/V-Halbleitern auf Si- (oder GaP)-Substraten Versetzungen entstehen. Solche Versetzungen stören jedoch die Funktion der gesamten Halbleiterstruktur in erheblichem Maße, zumal funktionelle Schichtdicken inzwischen in atomaren Bereichen liegen. Im Falle hoher Schichtdicken führt der Unterschied der Gitterkonstanten sogar zu Verbiegungen des Substrates. Ursache hierfür ist letztendlich, dass bei hohen Abscheidungstemperaturen ein epitaktisches Wachstum von III/V-Halbleitern auf Si- bzw. GaP-Halbleitern stattfindet, jedoch bereits bei weniger hohen Abscheidungstemperaturen die Versetzungsbildung einsetzt. Kühlt die Halbleiterstruktur dann auf Raumtemperatur ab, so führen die aufgrund der unterschiedlichen thermischen Ausdehnungskoeffizienten entstehenden Unterschiede der Gitterkonstanten zu den vorstehend angesprochenen Verspannungen und Verwerfungen.

Zur Beherrschung der vorstehenden Probleme existieren verschiedene Ansätze. In der Literaturstelle EP 0380815 B1 ist beschrieben, dass GaAs-Schichten auf ein Si-Substrat unter Bildung von definierten Microcracks an vorbestimmten Orten abgeschieden werden können, wodurch Verwerfungen des Si-Substrates vermieden, zumindest jedoch reduziert werden. Diese Technologie ist jedoch aufgrund der mangelnden Kontrollierbarkeit von Microcracks in atomaren Maßstäben für hochintegrierte Schaltkreise ungeeignet.

Die Literaturstelle EP 0297483 beschreibt eine hybride integrierte Halbleiterstruktur, wobei auf einem Si-Substrat ein integrierter Schaltkreis auf Basis der Si-Technologie angebracht ist. Des Weiteren ist auf dem Si-Substrat ein optisch aktives Element in GaAs Technologie angeordnet. Eine elektrische Verbindung zwischen dem integrierten Schaltkreis und dem optisch aktiven Element wird jedoch nicht über einen direkten Kontakt oder über das Si-Substrat hergestellt, sondern vielmehr über eine elektrische Drahtverbindung. Auch diese Technologie ist für Anwendungen in hochintegrierten Schaltkreisen nicht geeignet.

Aus der Literaturstelle DE 10355357 ist es bekannt, im Rahmen von optisch aktiven Elementen auf Basis der III/V-Halbleiter eingerichteten Schichtstrukturen, Gitterkonstanten-bedingte Verspannungen beispielsweise durch zugverspannte Anpassungsschichten zu kompensieren. Durch die insofern bekannten Maßnahmen ist auch eine Modellierung elektronischer Eigenschaften möglich, wodurch bislang nicht zugängliche Emissionswellenlängen zugänglich werden.

Aus der Literaturstelle US 2004/0135136 A1 sind eine Mehrzahl verschiedender III/V-Halbleiter bekannt, wobei es sich stets um Schichten handelt, die nicht zum Ausbringen auf ein Si Substrat geeignet sind. Entsprechendes gilt für die Lieraturstellen EP 1257026 A2, US 6,233,264 B1, US 2004/0084667 A2, Merz et al., IEE Proc.-Oproelectron. 151(5):346-351 (2004), US 6,072,196, EP 1553670 A2, US 5,825,796, Ishizuka et al., Journal of Crystal Growth 272:760-764 (2004), und US 2004/0161009A1.

In der Literaturstelle EP 0896406 A2 sind Schichten optisch aktiver III/V-Halbleiter u.a. auf GaP oder Si Substraten beschrieben, wobei diese Schichten als III Komponente ausschließlich In enthalten. Tatsächlich sind solche Schichten nur für InP Substrate geeignet und bilden unerwünscht viele Versetzungen und fehlstellen auf Si oder GaP Substraten. Die Literaturstelle US 5,937,274 beschreibt sehr allgemein verschiedene Schichten auf verschiedenen Substraten.

Im Ergebnis besteht nach wie vor insbesondere für den Bereich hochintegrierter Schaltkreise der Bedarf, Baugruppen bzw. Schichtfolgen auf Basis der Si-Technologie sowie auf Basis der III/V-Halbleiter monolithisch miteinander zu verbinden.

Aus den Dokumenten H. Yonezu, "Control of structural defects in group II-V-N alloys grown on Si", Semiconductor Science and Technology IOP Publishing UK, Bd. 17, Nr. 8 2002-08-01, XP002468397 und US 5,937,274 sind verschiedene III/V Halbleiter bekannt.

### Technisches Problem der Erfindung

Der Erfindung liegt das technische Problem zugrunde, Mittel zur Schaffung von optisch aktiven Elementen auf Basis der III/V-Halbleiter auf Substraten der Si-Technologie oder GaP-Technologie anzugeben, wobei die Leitung elektrischer Signale der Si-basierten bzw. GaPbasierten Baugruppen zu und von den optisch aktiven Elementen integral, i. e. durch Kontakt von Schichten, gebildet ist, und zwar praktisch frei von nichtstrahlende Rekombinationszentren bildenden Versetzungen in dem III/V-Halbleiter bzw. an dessen Grenzfläche zur darunterliegenden Schicht. Der Erfindung liegt weiterhin das technische Problem zugrunde, stabile Lumineszenz- und Laserbauelemente auf Si-Substraten oder GaP-Substraten anzugeben, welche direkt, i. e. über Schichtkontakt, kontaktiert sind. Der Erfindung liegt des Weiteren das technische Problem zugrunde, eine monolithisch integrierte Halbleiterstruktur anzugeben, welche direkt, i. e. ohne drahtgebundene Verbindungsleitungen, Datenströme aus einer Si-technologiebasierten Prozessorschaltung als optisches Signal emittiert. Zudem liegt der Erfindung das Problem zugrunde, eine monolithisch integrierte Halbleiterstruktur anzugeben, mit deren Hilfe emittierte optische Signale auch moduliert und/oder detektiert werden können.

### Grundzüge der Erfindung und Ausführungsformen

Zur Lösung dieses technischen Problems lehrt die Erfindung den Gegenstand des Anspruchs 1
Im Falle eines P-freien Systems sollte In und/oder Sb enthalten sein, da diese Elemente wie P die durch den N-Einbau verursachten lokalen Verzerrungsfelder minimieren.

Bevorzugt sind insbesondere III/V-Halbleiter mit insbesondere den folgenden Zusammensetzungen:
a) x = 85 - 99 Mol-%, y = 1 - 15 Mol-%, a = 0,5 - 10 Mol-%, b = 70 - 98,5 Mol-%, c = 1 - 29,5 Mol-%, oder
b) x = 85 - 99 Mol-%, y = 1 - 15 Mol-%, a = 0,5 - 10 Mol-%, b = 70 - 98,5 Mol-%, c = 0 - 32 Mol-%, d = 1 - 10 Mol-%.

Insbesondere können x = >70 - 100 Mol-%, a = >1,3 oder >1,7 Mol-%, c = 0 - 32 Mol-%, und/oder b = 60 - 99,5 Mol-% sein. Bevorzugt ist auch c = oder zwischen 4 - 8 Mol.-%. Bevorzugt ist auch a = 4 oder 5,5 - 11 Mol.-%.

Die erfindungsgemäß eingesetzte Halbleiterklasse des Mischkristallsystems GaInNAsPSb zeichnet sich zum einen dadurch aus, dass sich aufgrund der Zusammensetzung, vermutlich der Beimischung von Stickstoff und/oder Phosphor, gitterangepasste oder kompressiv verspannte Schichtfolgen auf GaP- und/oder Si-Substraten ohne die Ausbildung von Versetzungen herstellen lassen. Zum anderen tritt ab einer Stickstoffkonzentration von > 0,5 Mol-% in Verbindung mit dem Phosphorgehalt eine Wechselwirkung der durch den Einbau von Stickstoff verursachten elektronischen Niveaus mit den Leitungsbandzuständen des stickstofffreien Mischkristallsystems am Γ-Punkt ein, die zu einer effektiven Rotverschiebung der fundamentalen Energielücke am Γ-Punkt führt und somit den Charakter als direkter Halbleiter des GaInNAsPSb-Materialsystems verstärkt. Beispielsweise für a = 1 - 10 Mol-%, b = 60 - 95 Mol-% und c = 2 - 15 Mol-%, vorzugsweise a = 3 - 5 Mol-%, b = 85 - 95 Mol-% und c = 4 - 8 Mol-%, ergibt sich eine fundamentale Energielücke von deutlich weniger als 1,8 eV, bis zu 1,4 eV herunter und tiefer. Dies verdeutlicht die drastische Beeinflussung der Energielücke durch die erfindungsgemäße Zusammensetzung dieses Halbleitersystems.

An die Schicht D) kann sich der folgende Schichtaufbau anschließen: E) optional eine zweite Anpassungsschicht und F) eine zweite stromführende Schicht bestehend aus dotiertem Si oder dotiertem GaP oder dotiertem (AlGa)P. Im Falle des (AlGa)P kann der Anteil Al 20 - 100 Mol-% betragen, wobei die Anteile Al und Ga stets 100 Mol-% ergeben. Die Schicht B) kann p- oder n-dotiert sein. Im Falle der Einrichtung der Schicht F) kann die Schicht F) p-dotiert sein, wenn die Schicht B) n-dotiert ist, und umgekehrt.

In aller Regel wird das optische Element einen Schichtaufbau (D1-D2-D3)ₙ aufweisen, wobei die Schicht D2 eine Quantum Well Schicht aus einem erfindungsgemäßen Halbleiter ist, wobei die Schichten D1 und D3 Barriereschichten sind, und wobei n = 1 - 15, ist. Mit einem solchen optisch aktiven Element lassen sich sowohl Lumineszenzdioden als auch Laserdioden aufbauen. Anschließend an eine der endständigen Schichten D1 oder D3 kann eine Barriereschicht D4 angeschlossen sein. Es wird sich empfehlen, wenn die Barriereschichten Halbleiter mit der Zusammensetzung GaₚIn_{q}NᵣPₛAsₜ sind, wobei p = 85 - 100 Mol-%, q = 0 - 15 Mol-%, r = 0 - 15 Mol-%, s = 60 - 10 Mol-% und t = 0 - 40 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im Wesentlichen 1:1 beträgt, und wobei die Barriereschicht eine Schichtdicke von vorzugsweise 5 - 50 nm aufweist. Bevorzugte Bereiche sind: p = 90 - 100 Mol-%, q = 0 - 10 Mol-%, r = 0 - 10 Mol-%, s = 70 - 100 Mol-% und t = 0 - 30 Mol-%. Für die Schichtdicke ist ein Bereich von 2 - 20 nm bevorzugt. Eine Anpassungsschicht kann ein Halbleiter mit der Zusammensetzung GaₚIn_{q}NᵣPₛAsₜ sein, wobei p = 90 - 100 Mol-%, q = 0 - 10 Mol-%, r = 0 - 10 Mol-%, s = 70 - 100 Mol-% und t = 0 - 30 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im Wesentlichen 1:1 beträgt, und wobei die Anpassungsschicht eine Schichtdicke von vorzugsweise 50 - 500 nm aufweist.

Im Rahmen der erfindungsgemäßen monolithisch integrierten Halbleiterstruktur kann eine zwischen der Trägerschicht und dem optisch aktiven Element angeordnete stromführende Schicht und/oder Barriereschicht zugleich Anpassungsschicht sein.

Unterhalb und/oder oberhalb des optisch aktiven Elementes kann zumindest eine optische Wellenleiterschicht angeordnet sein, welche optisch an das optisch aktive Element gekoppelt ist. Auf diese Weise lassen sich Datenströme als optische Signale von dem emittierenden optisch aktiven Element zu einem optischen Empfänger an anderem Orte auf dem Träger leiten. Es versteht sich, dass zusätzlich oder alternativ andere Elemente zur Leitung optischer Signale verwendet werden können, wie beispielsweise Fibern oder dergleichen.

Eine Lumineszenzdiode oder auch eine vertikalemittierende Laserdiode ist dadurch herstellbar, dass zwischen den Schichten A) und D) und/oder außerhalb der Schicht F) zumindest eine periodische Reflexionsstruktur eingerichtet ist.

Vorzugsweise weist das optisch aktive Element eine fundamentale Emissionswellenlänge im Bereich von 700 - 1100 nm aus.

Die Erfindung betrifft des Weiteren die Verwendung eines erfindungsgemäßen Halbleiters zur Herstellung einer Lumineszenzdiode (LED), einer VCSEL (Vertical Cavity Surface Emitting Laser) Laserdiode, oder einer VECSEL (Vertical External Cavity Surface Emitting Laser) Laserdiode, sowie einer Modulator- oder einer Detektorstruktur.

Ein Verfahren zur Herstellung einer erfindungsgemäß eingesetzten Halbleiterschicht weist die folgenden Verfahrensschritte auf: ein Substrat auf Basis dotiertem oder undotiertem Si oder GaP wird in eine MOVPE-Apparatur (Metallorganische Gasphasenepitaxie) eingebracht, optional wird eine Oberfläche des Substrats in zumindest einem epitaktischen Beschichtungsschritt zunächst mit jeweils zumindest einer Anpassungsschicht, einer Barriereschicht, einer stromführenden Schicht, einer Wellenleiterschicht und/oder einer Reflexionsstruktur versehen, ein Trägergas wird mit Edukten in definierten Konzentrationen beladen, das beladene Trägergas wird über die Oberfläche des auf eine Temperatur im Bereich von 300°C bis 700°C erhitzten Substrates bzw. auf die Oberfläche der obersten Schicht auf dem Substrat für eine definierte Expositionsdauer geleitet, wobei Gesamtkonzentation der Edukte und Expositionsdauer mit der Maßgabe aufeinander abgestimmt sind, dass die Halbleiterschicht mit einer vorgegebenen Schichtdicke auf der Oberfläche des Substrats bzw. der Oberfläche der obersten Schicht auf dem Substrat epitaktisch gebildet wird.

Vorteilhafterweise werden im Rahmen der MOVPE Technologie als Edukte eingesetzt: C1-C5 Trialkylgallium, insbesondere Triethylgallium (Ga(C₂H₅)₃) und/oder Trimethylgallium (Ga(CH₃)₃), als Ga-Edukt, C1-C5 Trialkylindium, insbesondere Trimethylindium (In(CH₃)₃), als In-Edukt, Ammoniak (NH₃), Mono(C1-C8)alkylhydrazin, insbesondere Tertiärbutylhydrazin (t-(C₄H₉)-NH-NH₂), und/oder 1,1-Di(C1-C5)alkylhydrazin, insbesondere 1,1-Dimethylhydrazin ((CH₃)₂-N-NH₂), als N-Edukt, Arsin (AsH₃) und/oder C1-C5 Alkylarsin, insbesondere Tertiärbutylarsin (t-(C₄H₉)-AsH₂), als As-Edukt, Phosphin (PH₃) und/oder C1-C5 Alkylphosphin, insbesondere Tertiärbutylphosphin (t-(C₄H₉)-PH₂), as P-Edukt, und C1-C5 Trialkylantimon, insbesondere Trimethylantimon ((CH₃)₃Sb) und/oder Triethylantimon ((C₂H₅)₃Sb) als Sb-Edukt, wobei die C3-C5 Alkylgruppen linear oder verzweigt sein können.

Vorzugsweise werden die Edukte in folgenden Mol-Verhältnissen eingesetzt: As-Edukt/Gruppe- III-Edukte 5 - 300, P-Edukt/Gruppe-III-Edukte 0 - 500, N-Edukt/As-Edukt 0,1 - 10, optional Sb-Edukt/As-Edukt 0 - 1, wobei die Oberflächentemperatur des Substrats im Bereich von 500°C bis 630°C eingestellt ist, wobei der Gesamtdruck von Trägergas und Edukten im Bereich von 10 bis 1000 hPa oder bis 200 hPa eingestellt ist, wobei das Verhältnis des Partialdrucks der Summe aller Edukte zum Partialdruck des Trägergases zwischen 0,005 bis 0,1 liegt, und wobei die Abscheiderate 0,1 bis 10 *µ*m/h beträgt. Insbesondere können die folgenden Verhältnisse eingesetzt sein: As-Edukt/Gruppe-III-Edukte 10 - 100, beispielsweise 10 - 30, P-Edukt/Gruppe-III- Edukte 1 - 100, beispielsweise 1 - 10, N-Edukt/As-Edukt 1 - 10, beispielsweise 3 - 8. Die Oberflächentemperatur kann vorzugsweise im Bereich von 500°C bis 650 °C, insbesondere 550°C bis 600°C, liegen.

Der Gesamtdruck von Trägergas und Edukte kann im Bereich von 20 - 100 hPa liegen. Das Verhältnis des Partialdrucks aller Edukte zum Partialdruck des Trägergases kann im Bereich 0,01 bis 0,05 liegen. Die Abscheiderate kann zwischen 0,1 - 5 *µ*m/h, insbesondere 0,5 bis 3 *µ*m/h, betragen.

Grundsätzlich richten sich die genauen Konzentrationen der Edukte nach den thermischen Zerlegungseigenschaften der jeweiligen Edukte im MOVPE Prozess. Die Wachstumsgeschwindigkeit der Schicht wird dabei durch die Konzentrationen der Gruppe-III-Edukte bestimmt. Auf Basis der dem Fachmann bekannten unterschiedlichen Zerlegungseigenschaften der Ga- und ggf. In-Edukte werden je nach gewählter Abscheidetemperatur (Oberflächentemperatur des Substrats) geeignete Eduktkonzentrationen eingestellt, die zu den gewünschten Gruppe-III-Konzentrationen der jeweiligen Elemente in der erfindungsgemäßen Halbleiterschicht führen. Aufgrund der bekannten temperaturabhängigen, inkongruenten Verdampfung der Gruppe-V-Edukte bzw. Spezies von der Wachstumsoberfläche von III/V-Verbindungshalbleitern sollten die jeweiligen Gruppe-V-Eduktkonzentrationen in der MOVPE-Abscheidung sorgfältig auf die gewünschten Konzentrationen in der erfindungsgemäßen Halbleiterschicht als Funktion der gewählten Abscheidetemperatur im Überschuss eingestellt werden. Dies ist für den Fachmann ggf. durch einfache Versuche einstellbar. Für höhere Abscheidetemperaturen bzw. schlechter zerlegende Edukte müssen ggf. noch höhere V/III- aber auch noch höhere N/As-Verhältnisse als vorstehend angegeben, gewählt werden. Für niedrigere Abscheidetemperaturen gilt entsprechend das umgekehrte Verhalten.

Alternativ zu MOVPE können als Epitaxieverfahren selbstverständlich auch andere Epitaxieverfahren, wie MBE (Molekularstrahlepitaxie), auch unter Einschluss von Gasquellen insbesondere für die Gruppe V-Komponenten (Gas-Source MBE, GS-MBE), CBE (Chemical Beam Epitaxie) oder auch MOMBE (Metallorganische Molekularstrahlepitaxie) genannt, eingesetzt werden. Diese Verfahren können mit Hilfe der üblichen und per se bekannten Epitaxie-Apparaturen ausgeführt werden, wo dann die jeweils geeigneten und per se bekannten Edukte bzw. Quellen einzusetzen sind. Die jeweiligen Bedingungen sind durch den Fachmann unschwer einstellbar.

### Definitionen

Ein direkter Halbleiter ist ein Halbleiter, bei welchem in der Bandstruktur Valenzbandmaximum und Leitungsbandminimum einander bei gleichem Kristallimpulsvektor gegenüber stehen. Demgegenüber stehen das Valenzbandmaximum sowie das Leitungsbandminimum bei einem indirekten Halbleiter einander nicht bei gleichem Kristallimpulsvektor gegenüber, sondern liegen bei unterschiedlichen Kristallimpulsvektor- en.

Als monolithische Halbleiterstruktur ist eine Struktur bezeichnet, bei welcher eine elektrische Kontaktierung verschiedener funktioneller Halbleiterbereiche über miteinander unmittelbar verbundene (vorzugsweise epitaktische) Schichten erfolgt. Demgegenüber erfolgt bei einer hybriden Halbleiterstruktur eine elektrische Verbindung zwischen verschiedenen funktionellen Halbleiterbereichen über Hilfsverbindungen, wie beispielsweise Drahtverbindungen.

Ein n-dotierter Halbleiter ist ein Halbleiter, in welchem die elektrische Leitung über Elektronen aufgrund von Donatoratomen mit überschüssigen Valenzelektronen erfolgt. Für die n-Dotierung von Silicium kommen beispielsweise in Frage Stickstoff, Phosphor, Arsen und Antimon. Für die n-Dotierung von GaP- oder (AlGa)P-Halbleitern kommen beispielsweise in Frage Silicium und Tellur. Bei einem p-dotierten Halbleiter erfolgt die elektrische Leitung über Löcher durch Einbau von Akzeptoratomen. Für Silicium kommen als Akzeptoren in Frage Bor, Aluminium, Gallium und Indium. Für GaP oder (AlGa)P kommen in Frage Akzeptoren wie beispielsweise Magnesium, Zink oder Kohlenstoff.

Ein Halbleiter ist typischerweise undotiert, wenn die Konzentration von Donator- oder Akzeptoratomen unterhalb von 10⁵ cm⁻³ liegt. Dotierte Halbleiter enthalten in der Regel Konzentrationen von oberhalb 10¹⁵ cm⁻³.

Eine stromführende Schicht besteht aus einem Halbleiter, welcher in einem Maße dotiert ist, dass eine für die Zurverfügungstellung einer definierten elektrischen Leistung ausreichende Leitfähigkeit gegeben ist.

Erfindungsgemäße III/V-Halbleiter sind typischerweise kompressiv verspannt. Zum Zwecke der Gitteranpassung sowie der Modellierung der Bandstruktur sind Barriereschichten eingerichtet, welche zugverspannt sein können. Hierdurch wird eine Verspannungskompensation des erfindungsgemäßen III/V-Halbleiters erreicht.

Ein optisch aktives Element gemäß der Erfindung wandelt elektrische Energie in Lichtstrahlung um und emittiert diese, moduliert die Lichtstrahlung und/oder absorbiert Lichtstrahlung und wandelt diese in ein elektrisches Signal um. Für Laserdioden ist Anzahl von Schichtperioden n typischerweise 1 - 5. Für Lumineszenzdioden kann n aber auch bis zu 15 betragen. Für Modulatoren oder Detektorstrukturen kann n aber auch wesentlich größer sein und Werte bis zu 50 und darüber annehmen.

Eine Anpassungsschicht dient zur Kompensation von Verspannungen zwischen einem erfindungsgemäßen Halbleiterschicht bzw. einer Halbleiterstruktur auf Basis von III/V-Halbleitern auf Si- oder GaP-Substraten. Anpassungschichten tragen zur Lichtemission nicht bei.

Eine Quantum Well Schicht wird auch als Quantenfilm bezeichnet. Durch den beidseitigen Kontakt mit einer Barriereschicht werden die Ladungsträger in ihrer Bewegungsfreiheit eingeschränkt und befinden sich im Falle epitaktischer Schichten folglich in einem eindimensionalen Einschluss (Bewegung überwiegend in zwei Raumdimensionen). Optisch aktive Elemente mit dem erfindungsgemäßen Schichtaufbau werden auch Multiple Quantum Well (MQW) Strukturen genannt. Durch epitaktische Verspannungen zwischen den Quantum Well Schichten und den Barriereschichten lassen sich zudem die elektronischen Eigenschaften in Hinblick auf die fundamentale Bandlücke beeinflussen.

Optische Wellenleiterschichten sind aus dem Stand der Technik vielfältig bekannt. Lediglich beispielhaft wird hierzu auf die Literaturstelle "Semiconductor Optoelektronics: Physics and Technology", J. Singh, McGraw-Hill Inc., New York (1995) verwiesen.

Als periodische Reflexionsstruktur sind dielektrische und/oder epitaktische (λ/4) Vielschichtspiegel bezeichnet. Es handelt sich um sog. Distributed Bragg Reflektoren (DBR), die das aus dem optisch aktiven Element emittierte Licht zurückspiegeln und somit in dem Laserresonator den hochreflektierten Endspiegel darstellen. Ergänzend wird hierzu auf die Literaturstelle "Vertical-Cavity Surface-Emitting Lasers: Design, Fabrication, Characterization and Applications", Eds.: C. Wilmsen et al., Cambridge University Press, Cambridge (1999) verwiesen. Solche periodischen Reflexionsstrukturen können auch zum Zwecke der Stromzuführung p- oder n-dotiert sein. Dann übernehmen diese periodischen Reflexionsstrukturen gleichzeitig die Funktion einer stromführenden Schicht.

Erfindungsgemäße III/V-Halbleiter sind typischerweise bei Raumtemperatur bzw. Betriebstemperatur metastabil. Dies bedeutet, dass aufgrund der Thermodynamik der Zusammenhänge bei der betreffenden Temperatur keine stabile homogene Phase existieren dürfte, sondern ein Zerfall in zumindest zwei verschiedene Phasen erfolgen müsste. Dieser Zerfall ist jedoch kinetisch gehemmt. Zur Überwindung der kinetischen Hemmung müsste eine hohe Temperatur einwirken, und aus diesem Grunde können solche metastabilen Phasen nur bei vergleichsweise geringen Substrattemperaturen, typischerweise unter 700 °C epitaktisch abgeschieden werden. Nach der Abscheidung bei erniedrigten Temperaturen kann zur Reduktion nichtstrahlender Rekombinationszentren ein Ausheizschritt der erfindungsgemäßen Halbleiterschicht im Temperaturbereich von typischerweise 700 °C bis 850 °C eingesetzt werden. Hier kommen sowohl Gleichgewichtsausheizschritte, zum Beispiel direkt in einem MOVPE-Reaktor, als auch Nichtgleichgewichtsverfahren, wie z.B. "Rapid Thermal Annealing" (RTA) in Frage. Die jeweiligen Ausheiztemperaturen sind hierbei so zu wählen, dass kein Zerfall in verschiedene Phasen beobachtet wird.

Eine erfindungsgemäß eingesetzte Trägerschicht ist typischerweise ein GaP- oder Si-Einkristall. Es versteht sich, dass die Oberfläche eines solchen Einkristalles in fachüblicher Weise gereinigt und für die epitaktische Beschichtung vorbereitet sein kann. Hierzu wird ergänzend auf die Literaturstelle A. Ishizaka et al., J. Electrochem. Soc. 33:666 (1986) verwiesen.

Der Begriff "im Wesentlichen 1:1" umfasst den Bereich 0,8:1,2 - 1,2:0,8, insbesondere 0,9:1,1 - 1,1:0,9, vorzugsweise 0,95:1,05 - 1,05:0,95, und natürlich auch exakt 1:1.

### Ausführungsbeispiele

### Beispiel 1: Herstellung einer erfindungsgemäß eingesetzten Halbleiterschicht

Nach üblicher Vorbehandlung wird ein Si-Wafer (Hersteller: Wacker, Virginia Semiconductor) in eine MOVPE-Apparatur (Typ AIX200-GFR des Herstellers Aixtron) eingesetzt. Zunächst werden in fachüblicher Weise epitaktische Schichten auf dem Si-Wafer abgeschieden, welche in folgenden Beispielen näher erläutert sind. Auf die so erhaltene Oberfläche wird dann eine Schicht aus dem erfindungsgemäßen III/V-Halbleiter abgeschieden. Hierzu wird ein Inertgas-strom (H₂) mit den verschiedenen Edukten beladen. Als Edukte werden eingesetzt: Trimethylgallium oder Triethylgallium, Trialkylindium (sofern vorgesehen), 1,1-Dimethylhydrazin, Tertiärbutylarsin, Tertiärbutylphosphin und Trimethylantimon (sofern vorgesehen). Alle diese Edukte sind beispielsweise von Akzo Nobel HPMO erhältlich.

Für die Herstellung einer erfindungsgemäßen Halbleiterschicht mit einer beispielhaften Zusammensetzung von Ga(N_{0,037}As_{0,883}P_{0,08}) wurden die folgenden Bedingungen bei einem Gesamtreaktordruck von 50 hPa gewählt: Partialdrucke TEGa (Triethylgallium) 0,007 hPa, TBAs (Tertiärbutylarsin) 0,142 hPa, TBP (Tertiärbutylphosphin) 0,035 hPa und UDMHy (Dimethylhydrazin) 0,85 hPa. Hieraus ergeben sich die folgenden Verhältnisse: As/Ga-Verhältnis 20, P/Ga-Verhältnis 5, und N/As-Verhältnis 6.

Das beladene H₂-Trägergas mit einem Gesamtdruck von 50 hPa wird sodann für eine Dauer von 22 s über die auf 575 °C erwärmte Oberfläche des beschichteten Substrates geleitet. Es wird eine erfindungsgemäße Schicht mit der Dicke von 7,0 nm erhalten. Nach Ablauf der Expositionsdauer für die erfindungsgemäße Halbleiterschicht wird die MOVPE-Anlage auf die Abscheidebedingungen der entsprechenden Barrieren- oder Anpassungsschicht umgestellt.

### Beispiel 2: Herstellung eines optisch aktiven Elements

In der MOVPE-Apparatur des Beispiels 1 werden auf einen Si-Wafer zunächst in folgenden Beispielen erläuterte Schichten in fachüblicher Weise epitaktisch aufgewachsen. Anschließend werden abwechselnd jeweils eine Barriereschicht und eine Quantum Well Schicht abgeschieden, wobei die Abscheidung einer Barriereschicht den Abschluss bildet. Diese periodische Schichtstruktur umfasst insgesamt 5 Quantum Well Schichten. Als Quantum Well Schicht wird eine Schicht gemäß Beispiel 1 eingesetzt. Alle Quantum Well Schichten haben die gleiche Zusammensetzung. Als Barriereschichten wird GaP eingesetzt. Alle Barriereschichten haben die gleiche Zusammensetzung. Die Quantum Well Schichten haben jeweils Schichtdicken zwischen 2 und 20 nm. Die Barriereschichten haben Schichtdicken zwischen 5 und 500 nm.

### Beispiel 3: Erfindungsgemäße monolithische integrierte Halbleiterstruktur

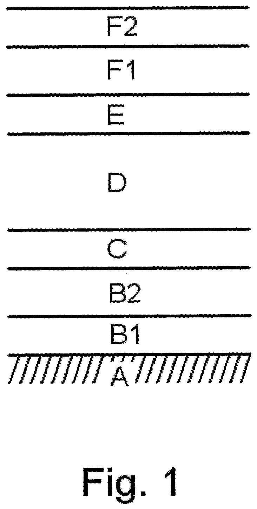

Eine erfindungsgemäße monolithische integrierte Halbleiterstruktur ist in der Figur 1 dargestellt. Zur Herstellung werden die Schichten B1) bis F2) subsequent auf einen Si-Wafer A epitaktisch aufgewachsen. Bei der Schicht B1) handelt es sich um p-dotiertes GaP. Als Dotierelement kommt Zink oder Magnesium zum Einsatz. Die Dotierkonzentration ist typischerweise 1 ^{∗} 10¹⁸ cm⁻³. Die Schichtdicke der Schicht B1) beträgt 5 - 300 nm. Bei der Schicht B1) handelt es sich um eine Kontaktschicht, welche auch stromführend ist. Anschließend wird die Schicht B2) erzeugt, welche aus p-dotiertem (AlGa)P gebildet ist. Dotiert wird mit Zink oder Magnesium in einer Dotierungskonzentration von typischerweise 1 ^{∗} 10¹⁸ cm⁻³. Die Aluminiumkonzentration beträgt mehr als 15 Mol-%, bezogen auf die Gesamtmenge an Gruppe-III-Elementen. Ein typischer Wert liegt im Bereich von 15 - 45 Mol-%. Alternativ kann auch p-dotiertes (AlGa)(NP) eingesetzt werden, wobei in Bezug auf die Dotierung und Aluminiumgehalt das Vorstehende gilt. Der Anteil an Stickstoff beträgt, bezogen auf die Gesamtmenge an Gruppe-V-Elementen, 0 - 4 Mol-%. Die Schichtdicke beträgt zwischen 500 und 1.500 nm. Bei der Schicht B2) handelt es sich um eine Wellenleiterschicht, welche zugleich als stromführende Schicht funktioniert. Die hierauf angeordnete Schicht C) besteht aus undotiertem GaP. Die Schichtdicke beträgt 50 - 100 nm. Es handelt sich um eine Separate Confinement Heterostruktur ähnlich einer Barriereschicht. Zudem funktioniert die Schicht C) als Anpassungsschicht. Der Übersichtlichkeit halber ist das hierauf angeordnete optisch aktive Element D) als eine einzige Schicht dargestellt. Tatsächlich enthält die Schicht D) eine Schichtstruktur gemäß Beispiel 2. Die Schicht E) entspricht der Schicht C). Beide Schichten können alternativ auch als Ga(NP)-, (GaIn)(NP)-, oder (GaIn)(NaSP)-Schichten ausgebildet sein. Hierbei kann der Stickstoffanteil, bezogen auf die Gruppe-V-Elemente, im Bereich von 0 - 10 Mol-% liegen. Im Falle der letztgenannten Schicht kann der Anteil an In bezogen auf die Gesamtmenge an Gruppe-III-Elementen, im Bereich von 0 - 15 Mol-% liegen. Die Schicht F1) entspricht der Schicht B2) und die Schicht F2) entspricht der Schicht B1) mit dem Unterschied, dass die Schichten F1) und F2) n-dotiert sind. Als Dotierelement ist Tellur mit einer Dotierungskonzentration von typischerweise 2 ^{∗} 10¹⁸ cm⁻³ eingesetzt. Die Schichtdicken der Schichten E), F1) und F2) entsprechen den Schichtdicken der Schichten C), B2) und B1) (in zum optisch aktiven Element spiegelsymmetrischer Reihenfolge).

Zur Verbesserung des Auskoppelgrades können für Lumineszenzdioden als optisch aktives Element zusätzlich noch (AlGa)/P/(AlGa)P-periodische Reflexionsstrukturen (DBR-Strukturen) mit unterschiedlichen Aluminiumgehalten in die unter dem optisch aktiven Element liegende Stromführungsschicht eingebaut werden. Der Aluminiumanteil aufeinander folgender Schichten ist hierbei unterschiedlich und beträgt, bezogen auf die Gesamtmenge an Gruppe-III-Elementen, 0 - 60 Mol-% bzw. 40 - 100 Mol-%. Alternativ können zur Verspannungskompensation dieser DBR-Strukturen jeweils auch (AlGa)(NP)-Einzelschichten eingesetzt werden, wobei die Al-Gehalte wie vorstehend und die N-Gehalte von 0 - 4 Mol-%, bezogen auf die Gesamtmenge an Gruppe-V-Elementen, zu wählen sind.

Für oberflächenemittierende Laserdioden (VCSEL) als optisch aktives Element wird das optisch aktive Element sowohl unterhalb als auch oberhalb durch eine Reflexionsstruktion der vorstehenden Art umschlossen. Zur Stromzuführung können entweder diese beiden DBR-Spiegelstrukturen n- bzw. p-dotiert sein, oder in die Gesamtstruktur werden zusätzlich sog. Intra-Cavity-Stromkontakte eingefügt, die es erlauben, die beiden DBR-Spiegel undotiert herzustellen. In entsprechender Weise lassen sich auch VECSEL-Strukturen herstellen.

### Beispiel 4: Fundamentale Energielücke eines erfindungsgemäßen Halbleiters

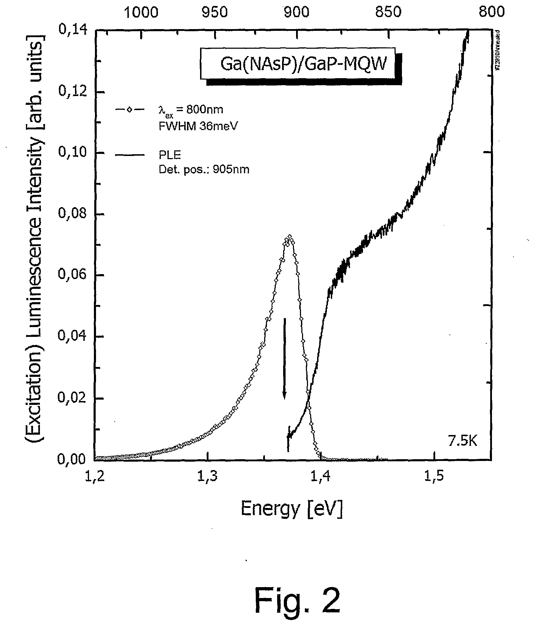

Eine gemäß Beispiel 1 hergestellte Halbleiterschicht mit 4 Mol-% Stickstoff, 90 Mol-% Arsen und 6 Mol-% Phosphor, bezogen auf die Gesamtmenge an Gruppe-V-Elementen, wurde mit Hilfe der Photolumineszenz-Anregungsspektroskopie untersucht. Das Ergebnis ist in der Figur 2 dargestellt. Die fundamentale Energielücke beträgt ca. 1,4 eV. Dieser Wert liegt deutlich unter dem ohne die Stickstoff-Wechselwirkung modellierten Wert von 1,8 eV und verdeutlicht die drastische Beeinflussung der Energielücke durch den Einbau von Stickstoff in Abstimmung mit den weiteren Anteilen an anderen Komponenten in das erfindungsgemäße Halbleitersystem.

### Beispiel 5: Versetzungsfreie Struktur erfindungsgemäßer aktiver optischer Elemente

Ein gemäß Beispiel 2 hergestelltes optisch aktives Element wurde mit Hilfe der hochauflösenden Röntgenbeugung (HR-XRD) und der Transmissionselektronenmikroskopie (TEM) untersucht.

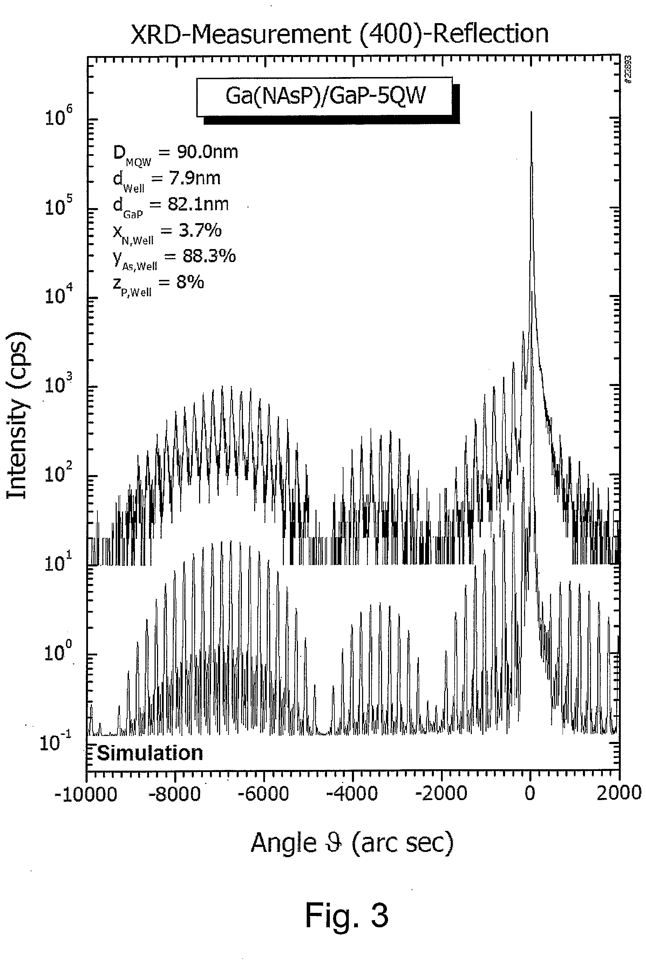

Figur 3 zeigt ein experimentelles HR-XRD-Profil (Figur 3 oben) im Vergleich zu einem theoretischen Profil gemäß der dynamischen Röntgenbeugungstheorie (Figur 3 unten). Die beobachtete Schärfe der einzelnen Beugungsreflexe und die nahezu perfekte Übereinstimmung des experimentellen mit dem theoretischen Beugungsprofil belegen die großflächig hervorragende strukturelle Schichtqualität ohne Ausbildung von Versetzungen.

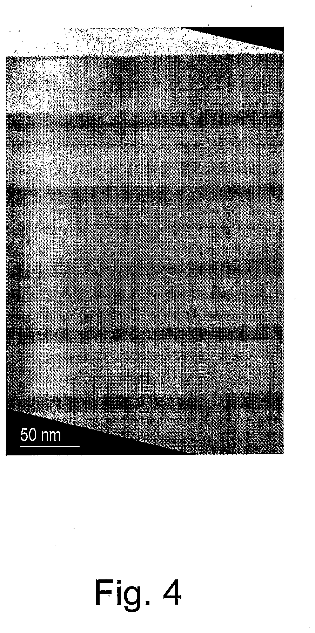

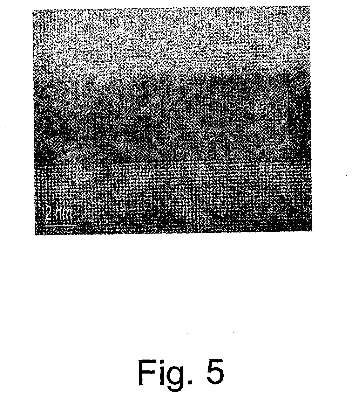

Figur 4 zeigt eine TEM-Dunkelfeldaufnahme. Hierin erkennt man als dunkle Schichten erfindungsgemäße pentanäre Schichten. Bei den helleren Schichten handelt es sich um Ga(NP)-Barriereschichten. Alle drei Schichten sind klar aufgelöst und es sind keinerlei ausgedehnte Defekte im kristallinen Aufbau erkennbar. In der hochauflösenden TEM-Aufnahme der Figur 5 zeigen sich beim Übergang der (dunklen) erfindungsgemäßen pentanären Schicht zur Barriereschicht nahezu atomar abrupte Grenzflächen, welche frei von Versetzungen und dergleichen sind.

### Beispiel 6: Halbleiter mit besonders niedriger fundamentaler Energielücke

Verschiedene analog Beispiel hergestellte Halbleiterschichten, welche jedoch Stickstoff im Bereich von 5,5 bis 11 Mol.-% (wie stets, bezogen auf die Gesamtmenge an Gruppe V Elementen) enthalten, zeigen bei der Untersuchung mittels Photolumineszenzspektroskopie bei 20°C eine fundamentale, direkte Energielücke von weniger als 1,2 eV, sogar weniger als 1,1 eV, was unterhalb der Energielücke von Silizium (1,124 eV) liegt. Halbleiterschichten mit einer Energielücke unterhalb jener von Silizium besonders für die Herstellung von Lumineszenz- und Laserdioden, die mit Si/SiO₂-basierten Wellenleiterstrukturen integriert sind. Insbesondere für diese Emissionsenergien kommt es nämlich nicht zu einer Absorption und damit einer Abschwächung des Lichtsignals in der Wellenleiterstruktur.

## Patentansprüche

1. Monolithische integrierte Halbleiterstruktur enthaltend den folgenden Schichtaufbau:
A) eine Trägerschicht auf Basis dotiertem oder undotiertem Si oder GaP,
B) optional einer ersten stromführenden Schicht bestehend aus dotiertem Si, dotiertem GaP, oder dotiertem (AlGa)P,
C) optional einer ersten Anpassungsschicht, und
D) einem optisch aktiven Element enthaltend eine Halbleiterschicht, welche aus einem III/V Halbleiter mit der Zusammensetzung GaₓIn_{y}NₐAs_{b}P_{c}Sb_{d} gebildet ist, wobei x = 70 - 100 Mol-%, y = 1 - 30 Mol-%, a = 0,5 - 15 Mol-%, b = 67,5 - 99,5 Mol-%, c = 0 - 39,5 Mol-% und d = 0 - 15 Mol-%, wobei sich x und y stets zu 100 Mol-% addieren, wobei sich a, b, c und d stets zu 100 Mol-% addieren, und wobei das Verhältnis der Summen aus x und y einerseits und a bis d andererseits im wesentlichen 1:1 beträgt.

2. Halbleiterstruktur nach Anspruch 1,
wobei c = 1 - 32,0 Mol-%.

3. Halbleiter Struktur nach einem der Ansprüche 1 oder 2,
wobei der Halbleiter ein direkter Halbleiter ist, und/oder
wobei das optisch aktive Element einen Schichtaufbau aufweist, wobei die Schicht D2 eine Quantum Well Schicht aus besagtem Halbleiter ist, wobei die Schichten D1 und D3 Barriereschichten sind, und wobei n = 1 - 50, insbesondere 1 - 15, wobei anschließend an eine der endständigen Schichten D1 oder D3 optional eine Barriereschicht D4 angeschlossen ist und/oder wobei optional die Barriereschichten Halbleiter mit der Zusammensetzung GaₚIn_{q}NᵣPₛAsₜ sind, wobei p = 85 - 100 Mol-%, q = 0 - 15 Mol-%, r = 0 - 15 Mol-%, s = 60 - 100 Mol-% und t = 0 - 40 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im wesentlichen 1:1 beträgt, und wobei die Barriereschicht eine Schichtdicke von vorzugsweise 5 - 50 nm aufweist, und/oder
wobei die erste und/oder die zweite Anpassungsschicht Halbleiter mit der Zusammensetzung GaₚIn_{q}NᵣPₛAsₜ sind, wobei p = 90 - 100 Mol-%, q = 0 - 10 Mol-%, r = 0 - 10 Mol-%, s = 70 - 100 Mol-% und t = 0 - 30 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im wesentlichen 1:1 beträgt, und wobei die Anpassungsschicht eine Schichtdicke von vorzugsweise 50 - 500 nm aufweist.

4. Halbleiterstruktur nach einem der Ansprüche 1 bis 3,
wobei eine zwischen der Trägerschicht und dem optisch aktiven Element angeordnete stromführende Schicht und/oder Barriereschicht zugleich Anpassungsschicht ist, und/oder
wobei unterhalb und/oder oberhalb des optisch aktiven Elementes zumindest eine optische Wellenleiterschicht angeordnet ist, welche optisch an das optisch aktive Element gekoppelt ist, und/oder wobei zwischen den Schichten A) und D) und/oder außerhalb der Schicht F) zumindest eine periodische Reflektionsstruktur eingerichtet ist, und/oder
wobei das optische aktive Element eine fundamentale Emissionswellenlänge im Bereich von 700 bis 1100 nm aufweist.

5. Verfahren zur Herstellung einer monolithischen integrierten Halbleiterstruktur nach einem der Ansprüche 1 bis 4,
wobei auf eine Trägerschicht A auf Basis dotiertem oder undotiertem Si oder GaP,
optional eine ersten stromführende Schicht B bestehend aus dotiertem Si, dotiertem GaP, oder dotiertem (AlGa)P epitaktisch aufgewachsen wird,
optional eine erste Anpassungsschicht C epitaktisch aufgewachsen wird, und
eine Multilayerstruktur D, welche ein optisch aktives Element, enthaltend eine Halbleiterschicht mit einem Halbleiter gemäß einem der Ansprüche 1 bis 6, bildet, epitaktisch aufgewachsen wird.

6. Verfahren nach Anspruch 5,
wobei auf das optisch aktive Element optional eine zweite Anpassungsschicht E, und auf das optisch aktive Element oder die zweite Anpassungsschicht eine zweite stromführende Schicht F bestehend aus dotiertem Si oder dotiertem GaP oder dotiertem (AlGa)P epitaktisch aufgewachsen wird, und/oder
wobei die Schicht B p- oder n-dotiert ist, wobei vorzugsweise die Schicht F) p-dotiert ist, wenn die Schicht B) n-dotiert ist, und wobei die Schicht F) n-dotiert ist, wenn die Schicht B) p-dotiert ist, und/oder
wobei das optisch aktive Element durch epitaktisches Aufwachsen von Schichten D1, D2, und D3 gebildet wird, wobei die Reihenfolge der epitaktischen Schritte mit der Maßgabe erfolgt, dass der Schichtaufbau ist, wobei die Schicht D2 eine Quantum Well Schicht aus einem Halbleiter gemäß einem der Ansprüche 1 bis 4 ist, wobei die Schichten D1 und D3 Barriereschichten sind, und wobei n = 1 - 50, insbesondere 1 - 15, wobei anschließend an eine der endständigen Schichten D1 oder D3 optional eine Barriereschicht D4 epitaktisch aufgewachsen wird, und/oder wobei die Barriereschichten optional Halbleiter mit der Zusammensetzung GaₚIn_{q}NᵣPₛAsₜ sind, wobei p = 85 - 100 Mol-%, q = 0 - 15 Mol-%, r = 0 - 15 Mol-%, s = 60 - 100 Mol-% und t = 0 - 40 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im wesentlichen 1:1 beträgt, und wobei die Barriereschicht eine Schichtdicke von vorzugsweise 5 - 50 nm aufweist, und/oder
wobei die erste und/oder die zweite Anpassungsschicht Halbleiter mit der Zusammensetzung GaₚIn_{q}NᵣPₛAsₜ sind, wobei p = 90 - 100 Mol-%, q = 0 - 10 Mol-%, r = 0 - 10 Mol-%, s = 70 - 100 Mol-% und t = 0 - 30 Mol-%, wobei sich p und q stets zu 100 Mol-% addieren, wobei sich r, s und t stets zu 100 Mol-% addieren, wobei das Verhältnis der Summen aus p und q einerseits und r bis t andererseits im wesentlichen 1:1 beträgt, und wobei die Anpassungsschicht eine Schichtdicke von vorzugsweise 50 - 500 nm aufweist, und/oder
wobei eine zwischen der Trägerschicht und dem optisch aktiven Element angeordnete stromführende Schicht und/oder Barriereschicht zugleich Anpassungsschicht ist, und/oder
wobei unterhalb und/oder oberhalb des optisch aktiven Elementes zumindest eine optische Wellenleiterschicht angeordnet wird, welche optisch an das optisch aktive Element gekoppelt ist, und/oder
wobei zwischen den Schichten A) und D) und/oder außerhalb der Schicht F) zumindest eine periodische Reflektionsstruktur eingerichtet wird, und/oder
wobei das optische aktive Element eine fundamentale Emissionswellenlänge im Bereich von 700 bis 1100 nm aufweist.

7. Verwendung eines Halbleiters nach Anspruch 6 zur Herstellung einer Lumineszenzdiode, einer VCSEL Laserdiode, einer VECSEL Laserdiode, einer Modulatorstruktur, oder einer Detektorstruktur.

8. Integrierte monolithische Halbleiterstruktur erhältlich mit einem Verfahren nach einem der Ansprüche 5 bis 6.

## Claims

1. A monolithic integrated semiconductor structure comprising the following layered structure:
A) a carrier layer based on doped or undoped Si or GaP,
B) optionally a first current-carrying layer consisting of doped Si, doped GaP, or doped (AlGa)P,
C) optionally a first adaptation layer, and
D) an optically active element comprising a semiconductor layer formed of a III/V semiconductor having the composition GaₓIn_{y}NₐAs_{b}P_{c}Sb_{d}, wherein x = 70 - 100 mol%, y = 1 - 30 mol%, a = 0.5 - 15 mol%, b = 67.5 - 99.5 mol%, c = 0 - 39.5 mol% and d = 0 - 15 mol%, x and y always adding to 100 mol%, a, b, c and d always adding to 100 mol%, and the ratio of the sums of x and y on the one hand and a to d on the other hand being essentially 1:1.

2. The semiconductor structure according to claim 1, wherein c = 1 - 32.0 mol%.

3. A semiconductor structure according to any of claims 1 or 2,
wherein the semiconductor is a direct semiconductor, and/or
wherein the optically active element has a layer structure (D1-D2-D3)ₙ, wherein the layer D2 is a quantum well layer of said semiconductor, wherein the layers D1 and D3 are barrier layers, and wherein n = 1 - 50, in particular 1 - 15, wherein a barrier layer D4 is optionally connected to one of the terminal layers D1 or D3, and/or wherein optionally the barrier layers are semiconductors with the composition GaₚIn_{q}NᵣPₛAsₜ, wherein p = 85 - 100 mol%, q = 0 - 15 mol%, r = 0 - 15 mol%, s = 60 - 100 mol% and t = 0 - 40 mol%, p and q always adding up to 100 mol%, r, s and t always adding up to 100 mol%, the ratio of the sums of p and q on the one hand and r to t on the other hand being essentially 1:1, and wherein the barrier layer has a layer thickness of preferably 5 - 50 nm, and/or
wherein the first and/or the second matching layer are semiconductors having the composition GaₚIn_{q}NᵣPₛAsₜ, wherein p = 90 - 100 mol%, q = 0 - 10 mol%, r = 0 - 10 mol%, s = 70 - 100 mol% and t = 0 - 30 mol%, p and q always adding to 100 mol%, r, s and t always adding to 100 mol%, the ratio of the sums of p and q on the one hand and r to t on the other hand being essentially 1:1, and wherein the matching layer has a layer thickness of preferably 50 - 500 nm.

4. A semiconductor structure according to any of claims 1 to 3,
wherein a current-carrying layer and/or barrier layer disposed between the carrier layer and the optically active element is at the same time an adaptation layer, and/or
at least one optical waveguide layer being arranged below and/or above the optically active element and being optically coupled to the optically active element, and/or at least one periodic reflection structure being set up between layers A) and D) and/or outside layer F), and/or
wherein the optical active element has a fundamental emission wavelength in the range of 700 to 1100 nm.

5. A process for fabricating a monolithic integrated semiconductor structure according to any of Claims 1 to 4,
wherein on a carrier layer A based on doped or undoped Si or GaP,
optionally a first current-carrying layer B consisting of doped Si, doped GaP, or doped (AlGa)P is epitaxially grown,
optionally, a first adaptation layer C is epitaxially grown, and
a multilayer structure D is epitaxially grown, which constitutes an optically active element containing a semiconductor layer with a semiconductor according to any one of claims 1 to 6.

6. A process according to claim 5,
wherein a second matching layer E is optionally epitaxially grown on the optically active element, and a second current-carrying layer F consisting of doped Si or doped GaP or doped (AlGa)P is epitaxially grown on the optically active element or the second matching layer, and/or
wherein the layer B is p- or n-doped, preferably the layer F) is p-doped when the layer B) is n-doped, and the layer F) is n-doped when the layer B) is p-doped, and/or
wherein the optically active element is formed by epitaxially growing layers D1, D2, and D3, wherein the order of the epitaxial steps is with the proviso that the layer structure is (D1-D2-D3)ₙ, wherein the layer D2 is a quantum well layer of a semiconductor according to one of claims 1 to 4, wherein the layers D1 and D3 are barrier layers, and wherein n = 1 - 50, in particular 1 - 15, wherein a barrier layer D4 is optionally epitaxially grown next to one of the terminal layers D1 or D3, and/or wherein the barrier layers are optionally semiconductors having the composition GaₚIn_{q}NᵣPₛAsₜ, wherein p = 85 - 100 mol%, q = 0 - 15 mol%, r = 0 - 15 mol%, s = 60 - 100 mol% and t = 0 - 40 mol%, p and q always adding up to 100 mol%, r, s and t always adding up to 100 mol%, the ratio of the sums of p and q on the one hand and r to t on the other hand being substantially 1:1, and wherein the barrier layer has a layer thickness of preferably 5 - 50 nm, and/or
wherein the first and/or the second matching layer are semiconductors having the composition GaₚIn_{q}NᵣPₛAsₜ, wherein p = 90 - 100 mol%, q = 0 - 10 mol%, r = 0 - 10 mol%, s = 70 - 100 mol% and t = 0 - 30 mol%, p and q always adding to 100 mol%, r, s and t always adding to 100 mol%, the ratio of the sums of p and q on the one hand and r to t on the other hand being essentially 1:1, and wherein the matching layer has a layer thickness of preferably 50 - 500 nm, and/or
wherein a current-carrying layer and/or barrier layer disposed between the carrier layer and the optically active element is at the same time an adaptation layer, and/or
wherein at least one optical waveguide layer which is optically coupled to the optically active element is arranged below and/or above the optically active element, and/or
wherein at least one periodic reflection structure being set up between layers A) and D) and/or outside layer F), and/or
wherein the optical active element has a fundamental emission wavelength in the range of 700 to 1100 nm.

7. Use of a semiconductor according to claim 6 for fabricating a luminescent diode, a VCSEL laser diode, a VECSEL laser diode, a modulator structure, or a detector structure.

8. An integrated monolithic semiconductor structure obtainable by a process according to any of claims 5 to 6.

## Revendications

1. Une structure semi-conductrice intégrée monolithique comprenant la structure en couches suivante :
A) une couche porteuse à base de Si ou de GaP dopé ou non dopé,
B) éventuellement une première couche porteuse de courant constituée de Si dopé, de GaP dopé ou de (AlGa)P dopé,
C) éventuellement une première couche d'adaptation, et
D) un élément optiquement actif comprenant une couche semi-conductrice formée d'un semi-conducteur III/V ayant la composition GaₓIn_{y}NₐAs_{b}P_{c}Sb_{d}, dans laquelle x = 70 - 100 mol%, y = 1 - 30 mol%, a = 0,5 - 15 mol%, b = 67,5 - 99,5 mol%, c = 0 - 39,5 mol% et d = 0 - 15 mole%, x et y s'ajoutant toujours à 100 mol%, a, b, c et d s'ajoutant toujours à 100 % mol%, et le rapport des sommes de x et y d'une part et a à d, d'autre part étant essentiellement 1 : 1.

2. La structure semi-conductrice selon la revendication 1, où c = 1 - 32,0 mol%.

3. Une structure semi-conductrice selon l'une quelconque des revendications 1 ou 2,
dans laquelle le semi-conducteur est un semi-conducteur direct, et/ou
où l'élément optiquement actif présente une structure en couches (D1-D2-D3)n, où la couche D2 est une couche à puits quantique dudit semi-conducteur, où les couches D1 et D3 sont des couches barrières, et où n = 1 - 50, en particulier 1 - 15, où une couche barrière D4 est éventuellement reliée à une des couches terminales D1 ou D3, et/ou où éventuellement les couches barrières sont des semiconducteurs avec la composition GaₚIn_{q}NᵣPₛAsₜ, où p = 85 - 100 mol%, q = 0 - 15 mol%, r = 0 - 15 mol%, s = 60 - 100 mol% et t = 0 - 40 mol%, p et q s'additionnant toujours à 100 mol%, r, s et t s'additionnant toujours à 100 mol%, le rapport des sommes de p et q d'une part et r à t d'autre part étant sensiblement 1 :1, et dans laquelle la couche barrière a une épaisseur de couche de préférence de 5 à 50 nm, et/ou
dans laquelle la première et/ou la deuxième couche d'adaptation sont des semi-conducteurs ayant la composition GaₚIn_{q}NᵣPₛAsₜ, où p = 90 - 100 mol%, q = 0 - 10 mol%, r = 0 - 10 mol%, s = 70 - 100 mol% et t = 0 - 30 mol%, p et q étant toujours ajoutés à 100 mol%, r, s et t étant toujours ajoutés à 100 mol%, le rapport des sommes p et q d'une part et r à t, d'autre part, étant essentiellement 1 :1, et dans laquelle la couche d'adaptation a une épaisseur de couche de préférence de 50 à 500 nm.

4. Une structure semi-conductrice selon l'une quelconque des revendications 1 à 3,
dans laquelle une couche porteuse de courant et/ou une couche barrière disposée entre la couche porteuse et l'élément optiquement actif est en même temps une couche d'adaptation, et/ou
au moins une couche de guide d'onde optique étant disposée au-dessous et/ou au-dessus de l'élément optiquement actif et étant couplée optiquement à l'élément optiquement actif, et/ou au moins une structure de réflexion périodique étant établie entre les couches A) et D) et/ou la couche extérieure F), et/ou
dans laquelle l'élément optique actif a une longueur d'onde d'émission fondamentale dans la gamme de 700 à 1100 nm.

5. Un procédé de fabrication d'une structure semi-conductrice intégrée monolithique selon l'une quelconque des revendications 1 à 4,
dans laquelle sur une couche support A à base de Si ou GaP dopé ou non dopé,
facultativement, une première couche B conductrice de courant constituée de Si dopé, de GaP dopé ou de (AlGa)P dopé est développée par épitaxie,
éventuellement, une première couche d'adaptation C est cultivée épitaxialement, et
une structure multicouche D à croissance épitaxiale d'un élément optiquement actif contenant une couche semi-conductrice avec un semi-conducteur selon l'une quelconque des revendications 1 à 6.

6. Procédé selon la revendication 5,
dans laquelle une seconde couche d'adaptation E est éventuellement développée épitaxialement sur l'élément optiquement actif, et une seconde couche F porteuse de courant constituée de Si dopé ou de GaP dopé ou de (AlGa)P dopé est développée épitaxialement sur l'élément optiquement actif ou la seconde couche d'adaptation, et/ou
dans laquelle la couche B est dopée en p ou n, de préférence la couche F) est dopée en p lorsque la couche B) est dopée en n, et la couche F) est dopée en n lorsque la couche B) est dopée en p, et/ou
dans laquelle l'élément optiquement actif est formé par des couches de croissance épitaxiale D1, D2 et D3, l'ordre des étapes épitaxiales étant précisé que la structure des couches est (D1-D2-D3)ₙ, la couche D2 étant une couche à puits quantique d'un semi-conducteur selon une des revendications 1 à 4, les couches D1 et D3 étant des couches barrières et n = 1 - 50, en particulier 1 - 15, dans laquelle une couche barrière D4 est éventuellement développée par épitaxie à côté de l'une des couches terminales D1 ou D3, et/ou dans laquelle les couches barrières sont éventuellement des semi-conducteurs ayant la composition GaₚIn_{q}NᵣPₛAsₜ, où p = 85 - 100 mol%, q = 0 - 15 mol%, r = 0 - 15 mol%, s = 60 - 100 mol% et t = 0 - 40 mol%, p et q s'additionnant toujours à 100 mol%, r, s et t s'additionnant toujours à 100 mol%, le rapport des sommes de p et q d'une part et r à t d'autre part étant sensiblement 1 :1, et dans laquelle la couche barrière a une épaisseur de couche de préférence de 5 à 50 nm, et/ou
dans laquelle la première et/ou la deuxième couche d'adaptation sont des semi-conducteurs ayant la composition GaₚIn_{q}NᵣPₛAsₜ, où p = 90 - 100 % mol%, q = 0 - 10 mol%, r = 0 - 10 mol%, s = 70 - 100 mol% et t = 0 - 30 mol%, p et q étant toujours ajoutés à 100 mol%, r, s et t étant toujours ajoutés à 100 mol%, le rapport des sommes p et q d'une part et r à t, d'autre part, étant essentiellement 1 :1, et dans laquelle la couche correspondante a une épaisseur de couche de préférence de 50 à 500 nm, et/ou
dans laquelle une couche porteuse de courant et/ou une couche barrière disposée entre la couche porteuse et l'élément optiquement actif est en même temps une couche d'adaptation, et/ou
dans laquelle au moins une couche de guide d'onde optique qui est couplée optiquement à l'élément optiquement actif est disposée au-dessous et/ou au-dessus de l'élément optiquement actif, et/ou
au moins une structure de réflexion périodique étant mise en place entre les couches A) et D) et/ou la couche extérieure F), et/ou
dans laquelle l'élément optique actif a une longueur d'onde d'émission fondamentale dans la gamme de 700 à 1100 nm.

7. Utilisation d'une semi-conducteur selon la revendication 6 pour fabriquer une diode luminescente, une diode laser VCSEL, une diode laser VECSEL, une diode laser VECSEL, une structure modulatrice ou une structure de détection.

8. Une structure semi-conductrice monolithique intégrée pouvant être obtenue par un procédé selon l'une quelconque des revendications 5 à 6.
